# EUROPEAN PATENT SPECIFICATION

(11) **EP 3 855 293 B1**
(45) Date of publication and mention of the grant of the patent: **08.11.2023**
(21) Application number: 18934046.6
(22) Date of filing: 18.10.2018
(51) Int. Cl.: G06F 3/0354, G06F 3/046

(54) **ELECTROMAGNETIC PEN**
ELEKTROMAGNETISCHER STIFT
STYLO ÉLECTROMAGNÉTIQUE

(30) Priority: 19.09.2018 CN 201811094870
(43) Date of publication of application: 28.07.2021
(73) Proprietor: Hanvon Ugee Technology Co., Ltd., Shenzhen, Guangdong 518000 (CN)
(72) Inventor: LI, Yuanzhi, Shenzhen, Guangdong 518000 (CN); DENG, Liming, Shenzhen, Guangdong 518000 (CN)
(74) Representative: Barker Brettell LLP
(86) International application number: PCT/CN2018/110834
(87) International publication number: WO 2020/056831

(56) References cited:
- WO-A1-2017/183526
- CN-A- 104 461 078
- CN-U- 204 066 032
- CN-U- 204 440 332
- US-A1- 2003 141 119
- US-A1- 2011 285 406
- US-B2- 8 692 814

## Description

### TECHNICAL FIELD

The present invention relates to the field of information input devices, and more particularly, to an electromagnetic pen.

### BACKGROUND

With the rapid development of computer technology, various hardware devices are changing with each passing day and emerging in endlessly. In input devices, there are various handwriting and drawing input devices to be more beneficial for input needs of handwriting and drawing, including a handwriting board, a drawing board, and the like, which can be collectively called the "drawing board".

The drawing board may be divided into a resistive type, a capacitive type, an electromagnetic type, a surface acoustic wave type, an optical (infrared) type, and the like in technology, wherein the electromagnetic type is most widely used, and has been recognized by the market. The electromagnetic drawing board is further divided into an active type and a passive type. Accordingly, an electromagnetic pen included in an electromagnetic drawing board system is also divided into an active type and a passive type. A change of a frequency of the passive electromagnetic pen may be implemented by a variable capacitance technology or a variable inductance technology. In the electromagnetic drawing board system adopting the variable inductance technology of the passive electromagnetic pen, a changed inductor is connected in parallel with a capacitor on a PCBA initially. An antenna board may emit a frequency to charge the pen, when the antenna board stops emitting, the pen may be changed from receiving energy to emitting energy, and the inductor on the pen is changed, and is connected in parallel with the fixed capacitor on the PCBA, which may change a frequency emitted by the pen, such that the antenna board is capable of obtaining different frequencies of the pen, and different changes of a pressure value of the pen (reflecting a weight sense) are generated.

The variable inductance technology of the passive electromagnetic pen is mostly used in a coil-wound solenoid, and an inductance value is changed by moving an iron core in the solenoid; or in two iron cores on a same axis, one iron core is wound with a coil, and the other iron core is not wound with a coil, and the inductance value is changed by changing a distance between the two iron cores. Since the coil needs to be wound on the solenoid in the former, a diameter of the pen may be larger than that of the pen in the latter. In addition, the coil is wound on the solenoid in the former, which increases a distance between the coil and the iron core, such that energy loss of the former is larger than that of the latter.

However, at present, the electromagnetic pen adopting a distance relationship structure of two iron cores is composed of many parts, each part has its own manufacturing error, and each part is made of different materials. Therefore, a problem of size inconsistency often occurs during assembly and production, which leads to a condition that an actual size of the electromagnetic pen in delivery is smaller than or larger than a standard size, thereby being not conducive to mass production.

Patent literature CN104461078A discloses an electromagnetic and capacitive pointer. The electromagnetic and capacitive pointer comprises a tube assembly and a conductive tube assembly, a first and a second ferrite cores, a non-magnetic and conductive pin, a control circuit board, a conductive pin holder and a holder. The non-magnetic and conductive pin, the conductive pin holder, the holder, the control circuit board and the conductive tube assembly constitute a conductive path.

### SUMMARY

In order to address the above technical problem, the present invention aims to provide an electromagnetic pen with a good size consistency.

The technical solution adopted in the present invention is as follows: an electromagnetic pen includes a housing and a pen body located in the housing, wherein the housing includes a front housing and a rear housing, the pen body includes a pen core, a first iron core, an iron core holder, and a PCBA circuit board, a coil is wound outside the first iron core, the first iron core is fixed at an end of the iron core holder close to a pen tip of the pen core, a second iron core is disposed in the iron core holder, and the pen core is configured to pass through a center of the first iron core, and then drive the second iron core to move; and an elastic structure with a ring shape is disposed between the PCBA circuit board and the iron core holder, a clamping slot is disposed on the PCBA circuit board, and an end portion matched with the clamping slot is disposed on the rear housing.

Further, a screw post is disposed behind the iron core holder, a screw hole is disposed in the PCBA circuit board, and the screw post is fixed in the screw hole by a screw.

Further, a thin film sheet is also disposed between the first iron core and the second iron core.

Further, a pen core clamp is also disposed in the iron core holder, and the pen core clamp is located behind the second iron core.

Further, a step is provided at a tail end of the pen core.

Further, a first through hole is formed in the center of the first iron core, a second through hole is formed in a center of the second iron core, and a diameter of the first through hole is larger than that of the second through hole.

Further, an outer diameter of the first iron core is smaller than that of the second iron core.

Further, the elastic structure adopts a silicone ring.

Further, the screw post is a cylinder, and the screw hole is an elliptical hole.

The present invention has the beneficial effects that: according to the electromagnetic pen of the present invention, the clamping slot is disposed on the PCBA circuit board of the pen body, and the end portion matched with the clamping slot is disposed on the rear housing, such that the rear housing pushes the pen body against the front housing when the front housing and the rear housing are combined by matching the clamping slot with the end portion, and the front housing is capable of being tightly attached or connected to the rear housing; and the elastic structure is additionally disposed between the iron core holder of the front housing and the PCBA circuit board, a manufacturing error of each part in an axial direction from the pen tip to a pen tail of the pen core is eliminated by an elastic margin of the elastic structure, such that an actual size of the electromagnetic pen in delivery is equal to a standard size, thereby being conductive to batch production, and meanwhile, the elastic structure may also play a role of buffering, thereby reducing a probability that the parts are damaged due to mechanical shock or wear, and prolonging a service life of the electromagnetic pen.

### BRIEF DESCRIPTION OF THE DRAWINGS

FIG. 1 is a schematic diagram of an overall structure of an electromagnetic pen of the present invention;
FIG. 2 is a stereoscopic exploded view of the electromagnetic pen of the present invention;
FIG. 3 is a schematic structural diagram of a PCBA circuit board of the present invention; and
FIG. 4 is a schematic structural diagram of a pen body of the electromagnetic pen of the present invention after assembly.

### DETAILED DESCRIPTION

The present invention is further explained hereinafter with reference to the accompanying drawings and the specific embodiments of the specification.

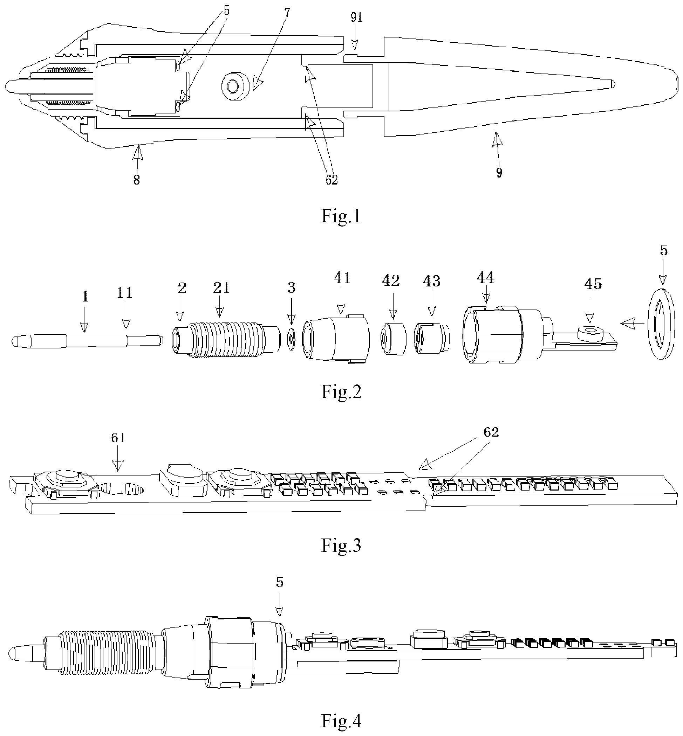

Referring to FIG. 1, FIG. 2, FIG. 3, and FIG. 4, an electromagnetic pen includes a housing and a pen body 7 located in the housing. The housing includes a front housing 8 and a rear housing 9, the pen body 7 includes a pen core 1, a first iron core 2, an iron core holder, and a PCBA circuit board, a coil 21 is wound outside the first iron core 2, the first iron core 2 is fixed at an end of the iron core holder close to a pen tip of the pen core 1, a second iron core 42 is disposed in the iron core holder, and the pen core 1 passes through a center of the first iron core 2, and then drives the second iron core 42 to move. An elastic structure 5 is disposed between the PCBA circuit board and the iron core holder, a clamping slot 62 is disposed on the PCBA circuit board, and an end portion 91 matched with the clamping slot 62 is disposed on the rear housing 9.

An electromagnetic pen with a distance relationship structure of two iron cores is used in the existing technology, which generally adopts a structure that an iron core without a wound coil is close to the pen tip. The pen tip pushes against the iron core without the wound coil, when the pen tip is stressed, the iron core without the wound coil may be forced to approach an iron core with a wound coil, resulting in a change of inductance. However, this structure often leads to a condition that a distance between the two iron cores cannot be too large, such that only an elastic element made of a very thin elastic material can be placed. After long-term use, the elastic element may fatigue elastically, causing the distance between the two iron cores to get out of control, such that the electromagnetic pen cannot be operated normally.

The distance relationship structure of two iron cores is also used in the electromagnetic pen of the present invention to change the inductance, but a difference in structure is that the iron core with the wound coil (i.e., the first iron core) is close to the pen tip, and the pen core passes through the center of the first iron core to push the iron core without the wound coil (i.e., the second iron core). This structure may provide an enough space behind the second iron core to design a pen core clamp, an internal elastic component, and other structures, such that the pen tip has an excellent force feedback performance. In addition, a front end of the pen is a coil-wound iron core structure, and compared with a variable inductance structure that the coil is wound on a solenoid, a diameter of the pen is smaller, such that an appearance of the pen may be made thinner and more beautiful. Compared with the structure that the coil is wound on the solenoid, more energy is also obtained by the pen. There is no too thin elastic component, and the product has a long service life. In the present invention, when the second iron core is pushed, an inductance value on the wound coil may be changed, and a changed inductor is connected in parallel with a capacitor on the PCBA circuit board. An antenna board may emit a frequency to charge the pen, when the antenna board stops emitting, the pen may be changed from receiving energy to emitting energy, and the coil-wound inductor on the pen is changed, and is connected in parallel with the fixed capacitor on the PCBA circuit board, which may change a frequency emitted by the pen, such that the antenna board is capable of obtaining different frequencies of the pen, and different changes of a pressure value of the pen are generated.

The PCBA circuit board is electrically connected with the coil 21 to convert the changed inductance into a change of the frequency, such that the antenna board is capable of obtaining different frequencies of the pen, and different pressure values of the pens are generated. Specifically, the PCBA circuit board is located behind the iron core holder, and may be fixedly connected with the iron core holder by a screw.

As shown in FIG 2, the first iron core 2 and the second iron core 42 of the present invention are both a hollow structure, which may accommodate the pen core 1 to move in an axial direction in an interior thereof. The pen tip of the pen core 1 is located on the left, and the tail end is located on the right. As shown in FIG 2, the iron core holder includes a front portion 41 and a bottom portion 44 which are matched with each other, the first iron core 2 is fixed on the front portion 41 of the iron core holder from a direction of the pen tip, while the second iron core 42 is loaded in the iron core holder from a direction of the pen tail. The first iron core 2 is fixed, and the second iron core 42 may be pushed by the pen core 1 in the iron core holder. The bottom portion 44 is capable of being combined with the front portion 41 in a rotating manner to form the iron core holder.

The clamping slot 62 mainly plays a role of fixing, and is capable of tightly attaching or connecting the front housing to the rear housing. The clamping slot 62 is located at a middle and rear portion of the PCBA circuit board (i.e., the tail end of the pen body 7), and may be clamped with the end portion 91 of the rear housing 9. As shown in FIG 1 and FIG 3, when the front housing 8 and the rear housing 9 are combined, the end portion 91 of the rear housing 9 may fixed by the clamping slot 62 through clamping, thereby pushing the whole pen body 7 against the front housing 8.

The elastic structure 5 has a certain elastic margin, which is used for eliminating and absorbing an error in an axial direction from the pen tip to the pen tail of the electromagnetic pen, such that an actual size of the electromagnetic pen in delivery is equal to a standard size. In addition, the elastic structure 5 may also play a role of buffering, which prevents the rear housing, the iron core holder, and other parts from being damaged due to mechanical shock or wear, thereby prolonging a service life. The elastic structure 5 may be implemented by a rubber ring (such as a silicone ring), an elastic metal sheet, a thin film sheet, and other elastic structures.

Referring to FIG 2 and FIG 3, further, as a preferred embodiment, a screw post 45 is disposed behind the iron core holder, a screw hole 61 is disposed in the PCBA circuit board, and the screw post 45 is fixed in the screw hole 61 by a screw.

Referring to FIG 2, further, as a preferred embodiment, a thin film sheet 3 is also disposed between the first iron core 2 and the second iron core 42.

A fixed and accurate distance must be kept between the first iron core 2 and the second iron core 42 of the present invention when the pen core 1 is not used for writing, such that the thin film sheet 3 with an accurate thickness is sandwiched therebetween to ensure the distance between the two iron cores.

Referring to FIG 2, further, as a preferred embodiment, a pen core clamp 43 is also disposed in the iron core holder, and the pen core clamp 43 is located behind the second iron core 42.

The pen core clamp 43 of the present invention is used for clamping the pen core 1.

Referring to FIG 2, further, as a preferred embodiment, a step 11 is provided at a tail end of the pen core 1.

The step 11 is used for pushing the second iron core 42.

Referring to FIG 2, further, as a preferred embodiment, a first through hole is formed in the center of the first iron core 2, a second through hole is formed in a center of the second iron core 42, and a diameter of the first through hole is larger than that of the second through hole.

In the present invention, the diameter of the first through hole of the first iron core 2 is larger than that of the second through hole of the second iron core 42, such that the pen core 1 is capable of pushing the second iron core 42 by the step 11 at the tail end of the pen core 1.

Further, as a preferred embodiment, an outer diameter of the first iron core is smaller than that of the second iron core.

In the present invention, the outer diameter of the second iron core without the wound coil is larger than that of the first iron core with the wound coil. The outer diameter of the second iron core is reduced close to one end of the first iron core, such that an overall appearance of the pen may not be abrupt due to the second iron core without the wound coil in the interior, thereby having a better consistency in overall appearance.

Referring to FIG 1 and FIG 2, further, as a preferred embodiment, the elastic structure 5 adopts a silicone ring.

Further, as a preferred embodiment, the screw post is a cylinder, and the screw hole is an elliptical hole.

In the present invention, the screw hole in the PCBA circuit board is the elliptical hole, and the screw post of the iron core holder is the cylinder, such that the PCBA circuit board is also capable of moving towards the pen tip or the pen tail for a small distance after the screw is tightened (a characteristic of the elliptical hole), thereby facilitating position regulation during installation and reducing installation errors.

The working principle of the electromagnetic pen of the present invention is as follows: when the pen tip of the pen core is stressed during writing, the pen core passes through the center of the first iron core and the center of the second iron core, and then is clamped by the pen core clamp, and the second iron core is pushed to move in the axial direction by the step at the tail end of the pen core, such that different distances are formed between the first iron core and the second iron core, thereby changing the inductance value on the coil. The changed inductor is connected in parallel with the fixed capacitor on the PCBA circuit board, such that the frequency emitted by the pen is changed, and different changes of a pressure value of the pen are generated. In addition, the clamping slot is disposed on the PCBA circuit board of the pen body of the present invention, and the end portion matched with the clamping slot is disposed on the rear housing, such that the rear housing pushes the pen body against the front housing when the front housing and the rear housing are combined by matching the clamping slot with the end portion, and the front housing is capable of being tightly attached or connected to the rear housing. The elastic structure is additionally disposed between the iron core holder of the front housing and the rear housing, the manufacturing error of each part in the axial direction from the pen tip to the pen tail of the pen core is eliminated by the elastic margin of the elastic structure, such that an actual size of the electromagnetic pen in delivery is equal to a standard size, thereby being conductive to batch production, and increasing a production first pass yield. Meanwhile, the elastic structure may also play a role of buffering, thereby reducing a probability that the parts are damaged due to mechanical shock or wear, and extending a service life of the electromagnetic pen.

The foregoing describes the preferred embodiments of the present invention in detail, but the present invention is not limited to the embodiments. Those skilled in the art may further make various modifications or substitutions without departing from the scope of the present invention as defined by the appended claims.

## Claims

1. An electromagnetic pen, comprising:
a housing; and
a pen body (7) located in the housing,
wherein the housing comprises a front housing (8) and a rear housing (9), the pen body (7) comprises a pen core (1), a first iron core (2), an iron core holder, and a PCBA circuit board, a coil (21) is wound outside the first iron core (2), the first iron core (2) is fixed at an end of the iron core holder close to a pen tip of the pen core (1), a second iron core (42) is disposed in the iron core holder, and the pen core (1) is configured to pass through a center of the first iron core (2), and then drive the second iron core (42) to move; and
wherein an elastic structure (5) with a ring shape is disposed between the PCBA circuit board and the iron core holder, a clamping slot (62) is disposed on the PCBA circuit board, and an end portion (91) matched with the clamping slot (62) is disposed on the rear housing (9).

2. The electromagnetic pen of claim 1, wherein a screw post is disposed behind the iron core holder, a screw hole is disposed in the PCBA circuit board, and the screw post is fixed in the screw hole by a screw, and the iron core holder includes a front portion and a bottom portion, the bottom portion being capable of being combined with the front portion in a rotating manner to form the iron core holder.

3. The electromagnetic pen of claim 1, wherein a thin film sheet is disposed between the first iron core (2) and the second iron core (42).

4. The electromagnetic pen of claim 3, wherein a pen core (1) clamp is disposed in the iron core holder, and the pen core (1) clamp is located behind the second iron core (42).

5. The electromagnetic pen of claim 4, wherein a step (11) is provided at a tail end of the pen core (1).

6. The electromagnetic pen of any one of claims 1 to 5, wherein a first through hole is formed in the center of the first iron core (2), a second through hole is formed in a center of the second iron core (42), and a diameter of the first through hole is larger than that of the second through hole.

7. The electromagnetic pen of any one of claims 1 to 5, wherein an outer diameter of the first iron core (2) is smaller than that of the second iron core (42).

8. The electromagnetic pen of any one of claims 1 to 5, wherein the elastic structure (5) adopts a silicone ring.

9. The electromagnetic pen of claim 2, wherein the screw post is a cylinder, and the screw hole is an elliptical hole.

## Patentansprüche

1. Elektromagnetischer Stift, umfassend:
ein Gehäuse und
einen Stiftkörper (7), der in dem Gehäuse angeordnet ist,
wobei das Gehäuse ein vorderes Gehäuse (8) und ein hinteres Gehäuse (9) umfasst, der Stiftkörper (7) einen Stiftkern (1), einen ersten Eisenkern (2), einen Eisenkernhalter und eine bestückte Leiterplatte umfasst, eine Spule (21) um das Äußere des ersten Eisenkerns (2) gewickelt ist, der erste Eisenkern (2) an einem Ende des Eisenkernhalters in der Nähe einer Stiftspitze des Stiftkerns (1) befestigt ist, ein zweiter Eisenkern (42) in dem Eisenkernhalter angeordnet ist und der Stiftkern (1) dazu ausgestaltet ist, durch eine Mitte des ersten Eisenkerns (2) zu gehen und dann den zweiten Eisenkern (42) zur Bewegung anzutreiben, und
wobei eine elastische Struktur (5) mit einer Ringform zwischen der bestückten Leiterplatte und dem Eisenkernhalter angeordnet ist, ein Klemmschlitz (62) auf der bestückten Leiterplatte angeordnet ist und ein zu dem Klemmschlitz (62) passender Endabschnitt (91) an dem hinteren Gehäuse (9) angeordnet ist.

2. Elektromagnetischer Stift nach Anspruch 1, wobei ein Schraubstift hinter dem Eisenkernhalter angeordnet ist, ein Schraubenloch in der bestückten Leiterplatte angeordnet ist und der Schraubstift mittels einer Schraube in dem Schraubenloch befestigt ist, und der Eisenkernhalter einen vorderen Abschnitt und einen unteren Abschnitt aufweist, wobei der untere Abschnitt mit dem vorderen Abschnitt drehend kombiniert werden kann, um den Eisenkernhalter zu bilden.

3. Elektromagnetischer Stift nach Anspruch 1, wobei eine Dünnfilmfolie zwischen dem ersten Eisenkernb (2) und dem zweiten Eisenkern angeordnet ist.

4. Elektromagnetischer Stift nach Anspruch 3, wobei eine Klemme des Stiftkerns (1) in dem Eisenkernhalter angeordnet ist und die Klemme des Stiftkerns (1) hinter dem zweiten Eisenkern (42) angeordnet ist.

5. Elektromagnetischer Stift nach Anspruch 4, wobei eine Stufe (11) an einem hinteren Ende des Stiftkerns (1) vorgesehen ist.

6. Elektromagnetischer Stift nach einem der Ansprüche 1 bis 5, wobei ein erstes Durchgangsloch in der Mitte des ersten Eisenkerns (2) ausgebildet ist, ein zweites Durchgangsloch in der Mitte des zweiten Eisenkerns (42) ausgebildet ist und ein Durchmesser des ersten Durchgangslochs größer als der des zweiten Durchgangslochs ist.

7. Elektromagnetischer Stift nach einem der Ansprüche 1 bis 5, wobei ein Außendurchmesser des ersten Eisenkerns (2) kleiner als der des zweiten Eisenkerns (42) ist.

8. Elektromagnetischer Stift nach einem der Ansprüche 1 bis 5, wobei die elastische Struktur (5) einen Silikonring annimmt.

9. Elektromagnetischer Stift nach Anspruch 2, wobei der Schraubstift ein Zylinder ist und das Schraubenloch ein elliptisches Loch ist.

## Revendications

1. Stylo électromagnétique, comprenant :
un boîtier ; et
un corps de stylo (7) situé dans le boîtier,
le boîtier comprenant un boîtier avant (8) et un boîtier arrière (9), le corps de stylo (7) comprenant un noyau de stylo (1), un premier noyau de fer (2), un support de noyau de fer et une carte de circuit PCBA, une bobine (21) étant enroulée à l'extérieur du premier noyau de fer (2), le premier noyau de fer (2) étant fixé à une extrémité du support de noyau de fer près d'une pointe de stylo du noyau de stylo (1), un second noyau de fer (42) étant disposé dans le support de noyau de fer, et le noyau de stylo (1) étant conçu pour passer à travers un centre du premier noyau de fer (2), et ensuite entraîner le second noyau de fer (42) à se déplacer ; et
une structure élastique (5) en forme d'anneau étant disposée entre la carte de circuit PCBA et le support de noyau de fer, une fente de serrage (62) étant disposée sur la carte de circuit PCBA, et une partie d'extrémité (91) correspondant à la fente de serrage (62) étant disposée sur le boîtier arrière (9).

2. Stylo électromagnétique selon la revendication 1, une colonne à vis étant disposée derrière le support de noyau de fer, un trou de vis étant disposé dans la carte de circuit PCBA, et la colonne à vis étant fixée dans le trou de vis par une vis, et le support de noyau de fer comprenant une partie avant et une partie inférieure, la partie inférieure pouvant être combinée avec la partie avant de manière rotative pour former le support de noyau de fer.

3. Stylo électromagnétique selon la revendication 1, une feuille mince étant disposée entre le premier noyau de fer (2) et le second noyau de fer (42).

4. Stylo électromagnétique selon la revendication 3, une pince de noyau de stylo (1) étant disposée dans le support de noyau de fer, et la pince de noyau de stylo (1) étant située derrière le second noyau de fer (42).

5. Stylo électromagnétique selon la revendication 4, un gradin (11) étant fourni au niveau de l'extrémité arrière du noyau de stylo (1).

6. Stylo électromagnétique selon l'une quelconque des revendications 1 à 5, un premier trou traversant étant formé au centre du premier noyau de fer (2), un second trou traversant étant formé au centre du second noyau de fer (42), et un diamètre du premier trou traversant étant plus grand que celui du second trou traversant.

7. Stylo électromagnétique selon l'une quelconque des revendications 1 à 5, le diamètre extérieur du premier noyau de fer (2) étant plus petit que celui du second noyau de fer (42).

8. Stylo électromagnétique selon l'une quelconque des revendications 1 à 5, la structure élastique (5) adoptant un anneau en silicone.

9. Stylo électromagnétique selon la revendication 2, la colonne à vis étant un cylindre et le trou de vis étant un trou elliptique.
